# EUROPEAN PATENT APPLICATION

(11) **EP 3 910 349 A1**
(43) Date of publication of application: **17.11.2021**
(21) Application number: 20914786.7
(22) Date of filing: 12.11.2020
(51) Int. Cl.: G01R 19/165, H01M 10/48, G01R 31/382, H01M 10/42

(54) **APPARATUS AND METHOD FOR BATTERY ABNORMAL CONDITION PREDICTION, AND BATTERY MANAGEMENT SYSTEM PROVIDING SAME METHOD**

(30) Priority: 17.03.2020 KR 20200032696
(71) Applicant: LG CHEM, LTD., Yeongdeungpo-gu, Seoul 07336 (KR)
(72) Inventor: The designation of the inventor has not yet been filed
(74) Representative: Plasseraud IP
(86) International application number: PCT/KR2020/015900
(87) International publication number: WO 2021/187715

(57) **Abstract**

The present invention relates to an apparatus and a method that detect an abnormal behavior of a battery, and a battery management system providing the same, and a battery abnormal condition prediction apparatus that detects an abnormal behavior of a battery according to the present invention includes: a receiving portion that receives information indicating a temperature value, a pressure value, and a gas concentration value respectively from a temperature sensor that measures a temperature inside a battery module, a pressure sensor that measures a pressure inside the battery module, and a gas sensor that measures a gas concentration inside the battery module; a comparison portion that compares the temperature value, the pressure value, and the gas concentration value with a first threshold value, a second threshold value, and a third threshold value, respectively; and a detection portion that determines that an abnormal behavior of the battery has occurred when the comparison result shows that the pressure value exceeding the second threshold value falls below the second threshold value or the gas concentration value exceeds the third threshold value, while the temperature value exceeds the first threshold value.

## Description

### [Technical Field]

### CROSS-REFERENCE TO RELATED APPLICATION(S)

This application claims priority to and the benefit of Korean Patent Application No. 10-2020-0032696 filed in the Korean Intellectual Property Office on March 17, 2020, the entire contents of which are incorporated herein by reference.

The present invention relates to a method for improving battery safety, and more particularly, it relates to an apparatus that can predict abnormal conditions of a battery by detecting thermal runaway in a battery cell in advance, a method thereof, and a battery management system providing the same.

### [Background Art]

In recent years, as the demand for portable electronic products such as laptops, video cameras, portable phones, and the like has been rapidly increasing, and the development of energy storage batteries, robots, satellites, electric vehicles, and the like is in full swing, researches on a high performance battery that is capable of iterative charging and discharging has been actively underway. Currently commercially available rechargeable batteries include nickel cadmium batteries, nickel hydrogen batteries, nickel zinc batteries, and lithium rechargeable batteries. Among them, lithium rechargeable batteries have little memory effect compared to nickel-based rechargeable batteries, and thus they are free to charge and discharge, have very low self-discharge rates, and are in the spotlight as having a merit of high energy density.

In addition, as carbon energy is gradually depleted and interest in the environment is increasing, public attention is being focused on hybrid vehicles and electric vehicles (hereinafter, electric vehicles) in the United States, Europe, Japan, Korea, and around the world. The most essential component in such an electric vehicle is a vehicle battery that provides driving power to a vehicle motor. Since electric vehicles can obtain the driving power of the vehicle through charging and discharging of the battery, and they have superior fuel economy and do not discharge pollutant materials or reduce pollutant materials compared to automobiles using only engines, the number of users is gradually increasing.

Meanwhile, one of the biggest issues related to the battery is safety. Safety of the battery is recognized as an important issue from small devices such as laptops and mobile phones to mid- to large-sized devices such as automobiles and power storage systems because battery explosion or fire can lead to additional fires as well as damage to the devices equipped with them.

In particular, in the case of medium and large-sized batteries used in electric vehicles and the like, higher safety is required than with small batteries used in general portable electronic products. Since these medium and large-sized batteries generate a high voltage, they can generate a lot of heat by themselves. Specifically, due to various issues such as battery deterioration, overcharge, over-discharge, and shorts between terminals, thermal runaway that proceeds as an ignition explosion may occur. The thermal runaway generates heat continuously inside the battery cell, and is accompanied by gas generation and pressure increase. When this phenomenon exceeds a threshold point, an uncontrollable ignition explosion occurs.

A battery system monitors a battery pack by analyzing a voltage, a current, and a temperature measured by a battery management system (BMS). However, there is a limitation in that the battery thermal runaway cannot be detected in advance simply based on this. That is, conventionally, the focus is on suppressing and solving the battery thermal runaway after it occurs, and a system that detects and prevents it in advance has not been established.

### [Disclosure]

### [Technical Problem]

The present invention provides an apparatus and a method that detect an abnormal behavior of a battery that compares sensed values of a plurality of sensors, each sensing a temperature, a gas, and a pressure in a battery module, with predetermined threshold values, and a battery management system providing the same.

### [Technical Solution]

A battery abnormal condition prediction apparatus that detects an abnormal behavior of a battery according to one feature of the present invention includes: a receiving portion that receives information indicating a temperature value, a pressure value, and a gas concentration value respectively from a temperature sensor that measures a temperature inside a battery module, a pressure sensor that measures a pressure inside the battery module, and a gas sensor that measures a gas concentration inside the battery module; a comparison portion that compares the temperature value, the pressure value, and the gas concentration value with a first threshold value, a second threshold value, and a third threshold value, respectively; and a detection portion that determines that an abnormal behavior of the battery has occurred when the comparison result shows that the pressure value exceeding the second threshold value falls below the second threshold value or the gas concentration value exceeds the third threshold value, while the temperature value exceeds the first threshold value.

A battery abnormal condition prediction apparatus that detects an abnormal behavior of a battery according to one feature of the present invention includes: a receiving portion that receives information indicating voltages respectively corresponding to a temperature value, a pressure value, and a gas concentration value respectively from a temperature sensor that measures a temperature inside a battery module, a pressure sensor that measures a pressure inside the battery module, and a gas sensor that measures a gas concentration inside the battery module; a first comparator that compares a first voltage corresponding to the temperature value with a first threshold voltage; a second comparator that compares a second voltage corresponding to the pressure value with a second threshold voltage; a third comparator that compares a third voltage corresponding to the gas concentration with a third threshold voltage; and a detection portion that determines whether an abnormal behavior has occurred in the battery based on a level change in an output signal of the second comparator or a level change in an output signal of the third comparator under an output signal condition of the first comparator, which is when the first voltage is higher than the first threshold voltage.

The detection portion may detect occurrence of thermal runaway in the battery according to an output signal of the second comparator when the second voltage is lower than the second threshold voltage under the output signal condition of the first comparator, which is when the first voltage is higher than the first threshold voltage.

The detection portion may detect occurrence of thermal runaway in the battery according to an output signal of the third comparator when the third voltage is higher than the third threshold voltage under the output signal condition of the first comparator, which is when the first voltage is higher than the first threshold voltage.

The detection portion may determine occurrence of an electrolyte solution leakage of the battery according to an output signal of the third comparator when the third voltage is higher than the third threshold voltage.

A method for predicting an abnormal behavior of a battery according to another feature of the present invention includes: receiving information that indicates a temperature value, a pressure value, and a gas concentration value respectively from a temperature sensor that measures a temperature inside a battery module, a pressure sensor that measures a pressure inside the battery module, and a gas sensor that measures a gas concentration inside the battery module; comparing the temperature value, the pressure value, and the gas concentration value with a first threshold value, a second threshold value, and a third threshold value, respectively; and determining occurrence of an abnormal behavior of the battery when the comparison result shows that the pressure value exceeding the second threshold value falls below the second threshold value or the gas concentration value exceeds the third threshold value, while the temperature value exceeds the first threshold value.

A method for predicting an abnormal behavior of a battery according to another feature of the present invention includes: receiving information that indicates voltages respectively corresponding to a temperature value, a pressure value, and a gas concentration value respectively from a temperature sensor that measures a temperature inside a battery module, a pressure sensor that measures a pressure inside the battery module, and a gas sensor that measures a gas concentration inside the battery module; outputting a signal of a high level when a voltage of an object to be compared is higher than a predetermined threshold voltage and outputting a signal of low level when the voltage is not higher than the predetermined threshold voltage by a first comparator that compares a first voltage corresponding to the temperature value with a first threshold voltage, a second comparator that compares a second voltage corresponding to the pressure value with a second threshold voltage, and a third comparator that compares a third voltage corresponding to the gas concentration value with a third threshold voltage; and determining whether an abnormal behavior has occurred in the battery based on output signals of the first comparator, the second comparator, and the third comparator.

The determining whether the abnormal behavior has occurred in the battery may include determining occurrence of thermal runaway of the battery when the output signal of the first comparator is a high level and an output signal of the second comparator is changed to a low level from a high level.

The determining whether the abnormal behavior has occurred in the battery may include determining occurrence of thermal runaway of the battery when the output signal of the first comparator and the output signal of the third comparator both have the high level.

The determining whether the abnormal behavior has occurred in the battery may include determining an electrolyte solution leakage of the battery when the output signal of the third comparator has the high level.

A battery management system according to another feature of the present invention provides a method for predicting abnormality in the battery of any one of claim 6 to claim 10.

### [Advantageous Effects]

The present invention can provide a battery abnormal condition prediction apparatus, a method thereof, and a battery management system that are capable of detecting abnormal behavior of a battery with high reliability by overcoming difficult limitations in detection of battery thermal runaway by only a temperature sensor with the possibility of detecting the pressure change late, a gas sensor with uncertainty due to air flow, an a temperature change measured by the temperature sensor due to a characteristic of a shape (pouch) of a battery case with organic combinations of output signals of each sensor, and a battery management system thereof.

The present invention provides a battery abnormal condition prediction apparatus, a method thereof, and a battery management system that can prevent additional human and property damage due to fire by quickly and effectively detecting and responding to the thermal runaway of the battery before it occurs.

### [Description of the Drawings]

FIG. 1 shows a battery abnormal condition prediction apparatus according to an embodiment.
FIG. 2 is provided for description of an output signal of a first comparator according to a temperature voltage input according to the embodiment.
FIG. 3 is provided for description of an output signal of a second comparator according to a pressure voltage input according to the embodiment.
FIG. 4 is provided for description of an output signal of a third comparator according to a gas voltage input according to the embodiment.
FIG. 5 is provided for description of an output signal of a first determining portion using the output signals of the first comparator and the second comparator as inputs according to the embodiment.
FIG. 6 is provided for description of an output signal of a second determining portion using the output signals of the first comparator and the third comparator as inputs according to the embodiment.
FIG. 7 is a flowchart provided for description of a battery abnormal condition prediction method according to an embodiment.
FIG. 8 shows a battery system that includes a battery management system providing a battery abnormal condition prediction method according to an embodiment.

### [Mode for Invention]

Hereinafter, a preferable embodiment of the present invention will be described in more detail with reference to the accompanying drawings. Like reference numerals refer to like elements for easy overall understanding, and a duplicated description of like elements will be omitted. Further, the terms "module" and "unit" which are suffixes for the components used in the specification are granted or mixed by considering only easiness in preparing the specification and do not have meanings or roles distinguished from each other in themselves. Further, in describing the present invention, when it is determined that the detailed description of the publicly known art related to the present invention may obscure the gist of the present invention, the detailed description thereof will be omitted. Further, the accompanying drawings are only for easily understanding the embodiment disclosed in the specification and the technical spirit disclosed in the specification is not limited by the accompanying drawings, and it should appreciated that the accompanying drawings include all changes, equivalents, or substitutions included in the spirit and the technical scope of the present invention.

Terms including an ordinal number, such as first and second, are used for describing various constituent elements, but the constituent elements are not limited by the terms. The above terms are used only to discriminate one component from the other component.

It should be understood that, when it is described that an element is "coupled" or "connected" to another element, the element may be "directly coupled" or "directly connected" to the another element or "coupled" or "connected" to the another element through a third element. In contrast, it should be understood that, when it is described that an element is "directly coupled" or "directly connected" to another element, it is understood that no element is present between the element and the another element.

In this specification, it should be understood that the term "include" or "have" indicates that a feature, a number, a step, an operation, a component, a part, or a combination thereof described in the specification is present, but does not exclude a possibility of presence or addition of one or more other features, numbers, steps, operations, components, parts or combinations, in advance.

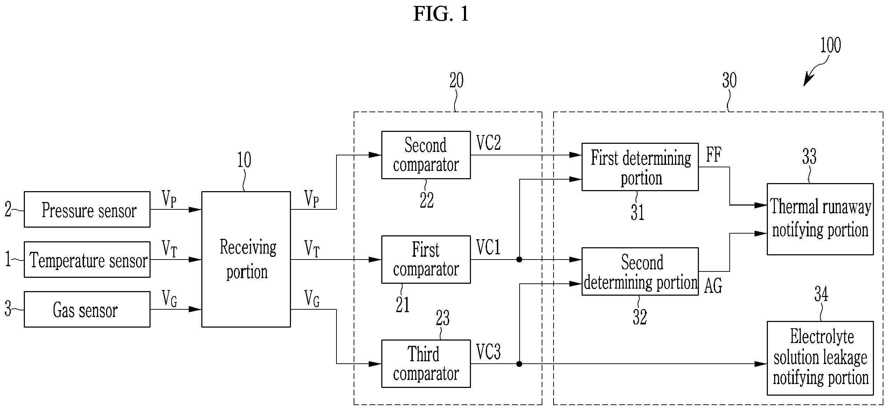

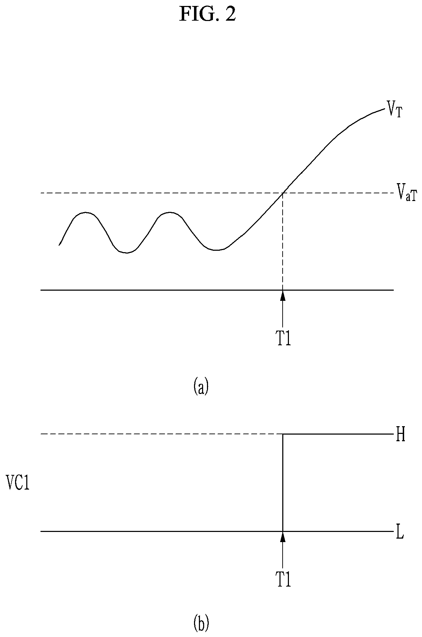

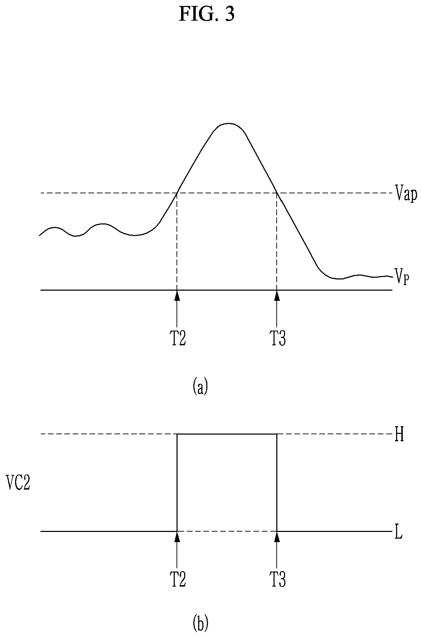

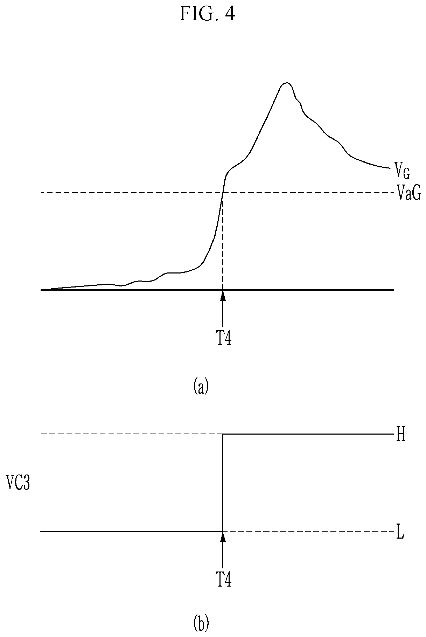

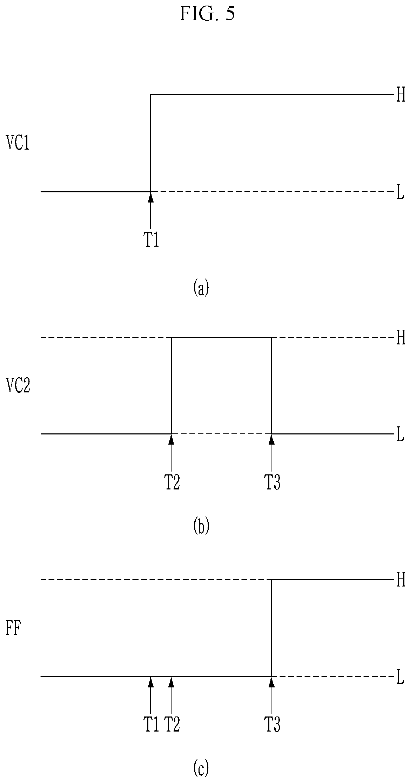

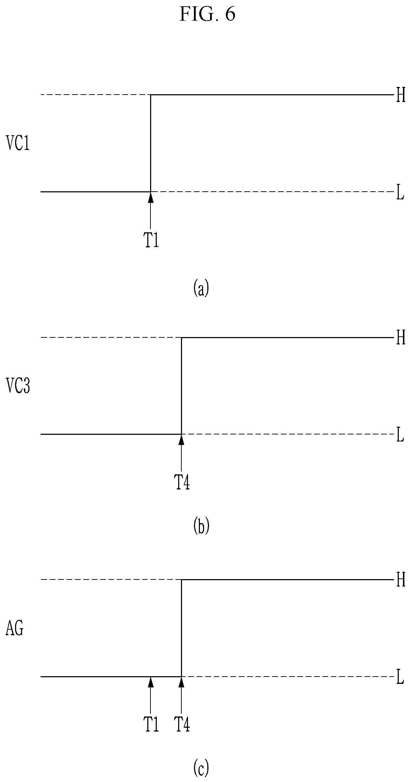

FIG. 1 shows a battery abnormal condition prediction apparatus according to an embodiment, FIG. 2 is provided for description of an output signal of a first comparator according to a temperature voltage input according to the embodiment, FIG. 3 is provided for description of an output signal of a second comparator according to a pressure voltage input according to the embodiment, FIG. 4 is provided for description of an output signal of a third comparator according to a gas voltage input according to the embodiment, FIG. 5 is provided for description of an output signal of a first determining portion using the output signals of the first comparator and the second comparator as inputs according to the embodiment, and FIG. 6 is provided for description of an output signal of a second determining portion using the output signals of the first comparator and the third comparator as inputs according to the embodiment.

Referring to FIG. 1, a battery abnormal condition prediction apparatus 100 includes a receiving portion 10, a comparison portion 20, and a detection portion 30.

Each configuration shown in FIG. 1 is an example to describe the configuration of the battery abnormal condition prediction apparatus 100, and changes such as at least two components being combined, one component being separated into at least two components, or an additional component being added are possible, and the embodiment shown in FIG. 1 does not limit the present invention.

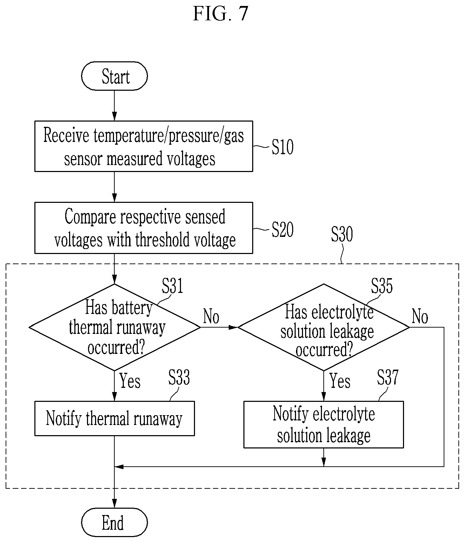

FIG. 7 is a flowchart provided for description of a battery abnormal condition prediction method according to an embodiment.

Hereinafter, referring to FIG. 1 to FIG. 7, an apparatus for predicting a battery abnormal condition, and a method thereof according to an embodiment, will be described.

First, the receiving portion 10 receives information indicating a temperature value, a pressure value, and a gas concentration value of a battery module measured by a temperature sensor 1, a pressure sensor 2, and a gas sensor 3, respectively (S10). For example, the receiving portion 10 may receive information indicating a temperature voltage V_{T}, a pressure voltage V_{P}, and a gas voltage V_{G}, which respectively correspond to the temperature value, the pressure value, and the gas concentration value of the battery module.

Next, the comparison portion 20 compares the temperature value, the pressure value, and the gas concentration value of the battery module respectively with a first threshold value, a second threshold value, and a third threshold value, and may transmit a comparison result to the detection portion 30 (S20).

Specifically, the comparison portion 20 compares a temperature voltage V_{T}, a pressure voltage V_{P}, and a gas voltage V_{G}, which respectively correspond to the temperature value, the pressure value, and the gas concentration value of the battery module with predetermined threshold values, and may output a comparison result as a digital signal. For example, the comparison portion 20 may include a voltage comparator that outputs a signal of a high level H when a voltage to be compared is greater than a predetermined threshold voltage, and outputs a signal of a low level L when the voltage to be compared is not larger than the threshold voltage.

Referring to FIG. 1, the comparison portion 20 may include a first comparator 21 that compares the temperature voltage V_{T} with the first threshold voltage, a second comparator 22 that compares the pressure voltage V_{P} with the second threshold voltage, and a third comparator 23 that compares the gas voltage V_{G} with the third threshold voltage.

Referring to FIG. 2, (a) is a graph provided for description of a change over time of the temperature voltage V_{T} corresponding to the temperature value of the battery module, and (b) is a graph displaying an output signal VC1 of the first comparator 21, which has the temperature voltage V_{T} as an input. The first comparator 21 receives the temperature voltage V_{T} in real time, compares the received temperature voltage V_{T} with a first threshold voltage V_{aT}, and outputs an output signal VC1 of a high level H or a low level L.

Since the temperature voltage V_{T} is not greater than the first threshold voltage V_{aT} until reaching T1, the output signal VC1 of the first comparator 21 is a low level L. At T1, the temperature voltage V_{T} becomes higher than the first threshold voltage V_{aT}, and therefore the output signal VC1 of the first comparator 21 is increased to the high level H.

Referring to FIG. 3, (a) is a graph provided for description of a change over time of the pressure voltage V_{P} corresponding to the pressure value of the battery module, and (b) displays an output signal VC2 of the second comparator 22, which has the pressure voltage V_{P}, as an input. The second comparator 22 receives the pressure voltage V_{P} in real time, compares the received pressure voltage V_{P} with a second threshold voltage V_{aP}, and outputs a signal VC2 of a high level H or low level L.

Since the pressure voltage V_{P} is not higher than the second threshold voltage V_{aP} until reaching T2, the output signal VC2 of the second comparator 22 has a low level L. At T2, the pressure voltage V_{P} becomes higher than the second threshold voltage V_{aP}, and therefore the output signal VC2 of the second comparator 22 is increased to a high level H. At T3, the pressure voltage V_{P} becomes lower than second threshold voltage V_{aP} again, and thus output signal VC2 of the second comparator 22 is decreased to the low level L.

Referring to FIG. 4, (a) is a graph provided for description of a change over time of the gas voltage V_{G} corresponding to the gas concentration value of the battery module, and (b) displays an output signal VC3 of the third comparator 23. The third comparator 23 receives the gas voltage V_{G} in real time, compares the received gas voltage V_{G} with a third threshold voltage V_{aG}, and outputs a signal VC3 of a high level H or a low level L.

Since the gas voltage V_{G} is not higher than the third threshold voltage V_{aG} until reaching T4, the output signal VC3 of the third comparator 23 has a low level L. At T4, the gas voltage V_{G} becomes higher than the third threshold voltage V_{aG}, and therefore the output voltage VC3 of the third comparator 23 is increased to the high level H.

Next, the detection portion 30 receives a comparison result of the first threshold value, the second threshold value, and the third threshold value for each of the temperature value, the pressure value, and the gas concentration value of the battery module from the comparison unit 20, and determines whether an abnormal behavior of the battery occurs based on the comparison result (S30).

For example, the detection portion 30 determines that thermal runaway of the battery occurs when the pressure value exceeding the second threshold value falls below the second threshold value or the gas concentration value exceeds the third threshold value while the temperature value exceeds the first threshold value. In addition, the prediction portion 30 may determine the occurrence of electrolyte solution leakage when the gas concentration value exceeds the third threshold value.

Referring to FIG. 1, the detection portion 30 includes a first determining portion 31, a second determining portion 32, a thermal runaway notifying portion 33, and an electrolyte solution leakage notifying portion 34, and determines abnormal behavior occurrence of the battery based on the signals VC1, VC2, and VC3 respectively from the first comparator 21, the second comparator 22, and the third comparator 23 and generates a corresponding notifying message.

Before thermal runaway occurs due to overcharge, over-discharge, or aging of the battery module, the temperature and gas concentration inside the battery module continuously rise until ignition, while the pressure increases rapidly and then decreases. That is, the pressure inside the battery module increases due to gas generation and then decreases when gas is discharged due to venting of the battery case. In the embodiment, a change in temperature and gas concentration inside the battery module may be monitored, or a change in temperature and pressure may be monitored, to detect whether battery thermal runaway occurs with high reliability.

Next, the first determining portion 31 and the second determining portion 32 respectively determine whether battery thermal runaway occurs based on the signals VC1, VC2, and VC3 output from the first comparator 21, the second comparator 22, and the third comparator 23 (S31).

The first determining portion 31 outputs a signal FF of the high level H when the output signal VC1 of the first comparator 21, used as a first input, is the high level H and the output signal VC2 of the second comparator 22, used as a second input, is changed to the low level L from the high level H.

For example, the first determining portion 31 includes a negative edge trigger flip-flop, and may output the signal FF of the high level H when a clock pulse receiving through the first input is "1 (high level)' and a clock pulse receiving through the second input is changed to "0 (low level)" from "1 (high level)". That is, the first determining portion 31 detects the occurrence of thermal runaway by detecting a temperature change that continuously rises inside the battery module and the pressure change that increases and decreases rapidly.

Referring to FIG. 5, (a) shows the output signal VC1 of the first comparator 21, (b) shows the output signal VC2 of the second comparator 22, and (c) shows the output signal FF of the first determining portion 31, which has the output signals of the first comparator 21 and the second comparator 22 as inputs. At T3, the output signal VC1 of the first comparator 21 has the high level H and the output signal VC2 of the second comparator 22 is changed to the low level L from the high level H, the output signal FF of the first determining portion 31 has the high level H.

The second determining portion 32 outputs a signal AG of the high level H when the output signal V1 of the first comparator 21, which is used as the first input, and the output signal VC3 of the third comparator 23, which is used as the second input, both have the high level H.

For example, the second determining portion 32 includes an AND gate and thus may output the signal AG of "1 (high level)" when the first input and the second input both have "1 (high level)" and output the signal AG of "0 (low level)" in the remaining cases. That is, the second determining portion 32 detects the occurrence of thermal runaway by detecting a temperature change that continuously rises inside the battery module and the pressure change that increases and decreases rapidly.

Referring to FIG. 6, (a) shows the output signal VC1 of the first comparator 21, (b) shows the output signal VC3 of the third comparator 23, and (c) shows the output signal AG of the second determining portion 32 which uses the outputs of the first comparator 21 and the third comparator 23 as inputs. At T4, the output signal VC1 of the first comparator 21 and the output signal VC3 of the third comparator 23 both have the high level H, and the output signal AG of the second determining portion 32 has the high level H.

Next, the thermal runaway notifying portion 33 determines occurrence of thermal runaway of the battery when at least one of the output signals of the first determining portion 31 and the second determining portion 32 has the high level H (S31, Yes), and may generate a corresponding notification message (S33). In this case, when the output signal VC3 of the third comparator 23 corresponds to "1 (high level)", the electrolyte solution leakage notifying portion 34 may determine occurrence of an electrolyte solution leakage due to thermal runaway and generate a corresponding notification message.

For example, the thermal runaway notifying portion 33 includes an OR gate, and thus may receive the output signal FF of the first determining portion 31 and the output signal AG of the second determining portion 32, and outputs a signal of "1 (high level)" when at least one of the received signals is "1 (high level)" and outputs a signal of "0 (low level)" when both of the received signals are "0 (low level)".

Next, when no thermal runaway occurs in the battery (S31, No), the electrolyte solution leakage notifying portion 34 additionally determines whether an electrolyte solution leakage has occurred due to problems other than the thermal runaway (S35). The electrolyte solution leakage may also occur due to soft venting caused by a problem in battery case sealing.

When the output signal VC3 of the third comparator 23 corresponds to "1 (high level)", the electrolyte solution leakage notifying portion 34 determines that the electrolyte solution leakage has occurred (S35, Yes) and may generate a corresponding notification message (S37).

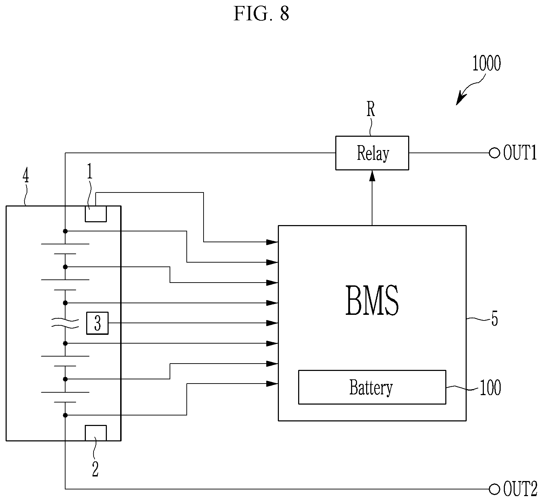

FIG. 8 shows a battery system that includes a battery management system providing a battery abnormal condition prediction method according to an embodiment.

Referring to FIG. 8, a battery system 1000 includes a temperature sensor 1, a pressure sensor 2, a gas sensor 3, a battery module 4, and a battery management system (BMS) 5.

The temperature sensor 1 measures a temperature inside the battery module 4, and transmits information indicating the measured temperature to the BMS 5. The temperature sensor 1 may be implemented as a thermistor, and a value measured by the thermistor may be information that indicates the measured temperature. In FIG. 8, one temperature sensor 1 is attached to the battery module 4, but the present invention is not limited thereto, and the temperature sensor 1 may be representatively attached to a cell where heat is concentrated, or two or more temperature sensors 1 may be attached to two or more cells.

The temperature sensor 1 is implemented as a negative temperature coefficient (NTC) type of thermistor, and thus may measure a temperature inside the battery module 4 and convert the measured temperature to a temperature voltage V_{T}. The temperature sensor 1 may transmit information that indicates the temperature voltage V_{T} to the BMS 5.

The pressure sensor 2 measures a pressure inside the battery module 4, and transmits information that indicates the measured pressure to the BMS 5. The pressure sensor 2 is implemented as a pressure sensitive resistor (PSR) type, and thus may measure a pressure (force) applied to a case surface of the battery module 4 and convert the measured pressure to a corresponding pressure voltage V_{P}. The pressure sensor 2 may transmit information that indicates the pressure voltage V_{P} to the BMS 5. In FIG. 8, the pressure sensor 2 is attached between the outermost cell in the battery module 4 and a case of the battery module 4, but the present invention is not limited thereto, and two or more pressure sensors 2 may be attached between two or more cells.

The gas sensor 3 measures a gas concentration inside the battery module 4 and transmits information that indicates the measured gas concentration to the BMS 5. The gas sensor 3 measures a concentration of predetermined gas such as CO, CO₂, and the like, and converts the measured gas concentration to a corresponding gas voltage V_{G}. The gas sensor 3 may transmit information that indicates the gas voltage V_{G} to the BMS 5.

The battery module 4 may supply requisite power to a plurality of battery cells that are connected in parallel/series. In FIG. 8, the battery module 4 includes a plurality of battery cells that are connected in series between two output terminals OUT1 (+) and OUT2 (-) of the battery system 1000, but the configurations and the connection relationship between the configurations shown in FIG. 8 are examples, and the present invention is not limited thereto.

The BMS 5 includes the battery abnormal condition prediction apparatus 100 according to the above-described embodiment of FIG. 1 to FIG. 7. The battery abnormal condition prediction apparatus 100 may predict occurrence of battery thermal runaway or an electrolyte solution leakage based on a temperature value, a pressure value, and a gas concentration of the battery module 4, respectively measured by the temperature sensor 1, the pressure sensor 2, and the gas sensor 3.

While this invention has been described in connection with what is presently considered to be practical embodiments, it is to be understood that the invention is not limited to the disclosed embodiments. On the contrary, it is intended to cover various modifications and equivalent arrangements included within the spirit and scope of the appended claims.

## Claims

1. A battery abnormal condition prediction apparatus that detects an abnormal behavior of a battery, comprising:
a receiving portion that receives information indicating a temperature value, a pressure value, and a gas concentration value respectively from a temperature sensor that measures a temperature inside a battery module, a pressure sensor that measures a pressure inside the battery module, and a gas sensor that measures a gas concentration inside the battery module;
a comparison portion that compares the temperature value, the pressure value, and the gas concentration value with a first threshold value, a second threshold value, and a third threshold value, respectively; and
a detection portion that determines that an abnormal behavior of the battery has occurred when the comparison result shows that the pressure value exceeding the second threshold value falls below the second threshold value or the gas concentration value exceeds the third threshold value, while the temperature value exceeds the first threshold value.

2. A battery abnormal condition prediction apparatus that detects an abnormal behavior of a battery, comprising:
a receiving portion that receives information indicating voltages respectively corresponding to a temperature value, a pressure value, and a gas concentration value respectively from a temperature sensor that measures a temperature inside a battery module, a pressure sensor that measures a pressure inside the battery module, and a gas sensor that measures a gas concentration inside the battery module;
a first comparator that compares a first voltage corresponding to the temperature value with a first threshold voltage;
a second comparator that compares a second voltage corresponding to the pressure value with a second threshold voltage;
a third comparator that compares a third voltage corresponding to the gas concentration with a third threshold voltage; and
a detection portion that determines whether an abnormal behavior has occurred in the battery based on a level change in an output signal of the second comparator or a level change in an output signal of the third comparator under an output signal condition of the first comparator, which is when the first voltage is higher than the first threshold voltage.

3. The battery abnormal condition prediction apparatus of claim 2, wherein
the detection portion detects occurrence of thermal runaway in the battery according to an output signal of the second comparator when the second voltage is lower than the second threshold voltage under the output signal condition of the first comparator, which is when the first voltage is higher than the first threshold voltage.

4. The battery abnormal condition prediction apparatus of claim 2, wherein the detection portion detects occurrence of thermal runaway in the battery according to an output signal of the third comparator when the third voltage is higher than the third threshold voltage under the output signal condition of the first comparator, which is when the first voltage is higher than the first threshold voltage.

5. The battery abnormal condition prediction apparatus of claim 2, wherein the detection portion determines occurrence of an electrolyte solution leakage of the battery according to an output signal of the third comparator when the third voltage is higher than the third threshold voltage.

6. A method for predicting an abnormal behavior of a battery, comprising:
receiving information that indicates a temperature value, a pressure value, and a gas concentration value respectively from a temperature sensor that measures a temperature inside a battery module, a pressure sensor that measures a pressure inside the battery module, and a gas sensor that measures a gas concentration inside the battery module;
comparing the temperature value, the pressure value, and the gas concentration value with a first threshold value, a second threshold value, and a third threshold value, respectively; and
determining occurrence of an abnormal behavior of the battery when the comparison result shows that the pressure value exceeding the second threshold value falls below the second threshold value or the gas concentration value exceeds the third threshold value, while the temperature value exceeds the first threshold value.

7. A method for predicting an abnormal behavior of a battery, comprising:
receiving information that indicates voltages respectively corresponding to a temperature value, a pressure value, and a gas concentration value respectively from a temperature sensor that measures a temperature inside a battery module, a pressure sensor that measures a pressure inside the battery module, and a gas sensor that measures a gas concentration inside the battery module;
outputting a signal of a high level when a voltage of an object to be compared is higher than a predetermined threshold voltage and outputting a signal of low level when the voltage is not higher than the predetermined threshold voltage by a first comparator that compares a first voltage corresponding to the temperature value with a first threshold voltage, a second comparator that compares a second voltage corresponding to the pressure value with a second threshold voltage, and a third comparator that compares a third voltage corresponding to the gas concentration value with a third threshold voltage; and
determining whether an abnormal behavior has occurred in the battery based on output signals of the first comparator, the second comparator, and the third comparator.

8. The method for predicting the abnormal behavior of the battery of claim 7, wherein the determining whether the abnormal behavior has occurred in the battery comprises determining occurrence of thermal runaway of the battery when the output signal of the first comparator is a high level and an output signal of the second comparator is changed to a low level from a high level.

9. The method for predicting the abnormal behavior of the battery of claim 7, wherein the determining whether the abnormal behavior has occurred in the battery comprises determining occurrence of thermal runaway of the battery when the output signal of the first comparator and the output signal of the third comparator both have the high level.

10. The method for predicting the abnormal behavior of the battery of claim 7, wherein the determining whether the abnormal behavior has occurred in the battery comprises determining an electrolyte solution leakage of the battery when the output signal of the third comparator has the high level.

11. A battery management system providing a method for predicting abnormality in the battery of any one of claim 6 to claim 10.
